# DEMANDE DE BREVET EUROPEEN

(11) **EP 2 657 956 A1**
(43) Date de publication de la demande: **30.10.2013**
(21) Numéro de dépôt: 13165028.5
(22) Date de dépôt: 24.04.2013
(51) Int. Cl.: H01L 21/306

(54) **Procédé de traitement de l'état de surface d'un substrat de silicium**

(30) Priorité: 27.04.2012 FR 1253893
(71) Demandeur: COMMISSARIAT A L'ENERGIE ATOMIQUE ET AUX ENERGIES ALTERNATIVES, 75015 Paris (FR)
(72) Inventeur: Le Tiec, Yannick, 38920 CROLLES (FR); Grenouillet, Laurent, 38140 RIVES (FR); Vinet, Maud, 38140 RIVES (FR); Wacquez, Romain, 13008 MARSEILLE (FR)
(74) Mandataire: Hautier, Nicolas

(57) **Abrégé**

La présente invention concerne un procédé de traitement de traitement de l'état de surface d'un substrat de silicium par voie chimique pour le contraste de la rugosité caractérisé par le fait qu'il comprend au moins deux cycles de traitement successifs, chaque cycle de traitement comprend une première étape comportant la mise en contact du substrat de silicium avec une première solution comprenant de l'acide hydrofluorhydrique (HF) dilué dans de l'eau puis une deuxième étape, réalisée à une température inférieure à 40°C, comportant la mise en contact de la couche de silicium avec une deuxième solution comprenant de l'ammoniaque (NH₄OH) et du peroxyde d'hydrogène (H₂O₂) dilués dans de l'eau (H₂O), de sorte à obtenir , à l'issue des cycles de traitement, une rugosité inférieure à 0,100 nanomètre sur une zone de 1µmx1µm.

L'invention trouvera son application dans le domaine de la microélectronique pour la fabrication de transistors, de surface pour panneaux photovoltaïques ou pour le collage moléculaire direct.

## Description

### DOMAINE TECHNIQUE

La présente invention concerne un procédé de traitement de l'état de surface d'un substrat de silicium.

L'invention trouve son application dans le domaine de la microélectronique pour la fabrication de transistors, de surface pour panneaux photovoltaïques ou pour le collage moléculaire direct.

### ETAT DE LA TECHNIQUE

Les surfaces de silicium sur isolant (SOI en anglais : Silicium On Insulator) vendues pour la fabrication de transistors présentent des caractéristiques prédéfinies par le fournisseur.

Pour fabriquer un transistor, diverses étapes de traitement sont effectuées sur cette surface SOI. Notamment, la formation d'un oxyde thermique et des étapes de gravure et de nettoyage de l'oxyde de grille.

Sur des « silicium on insulator », il est connu d'effectuer un traitement thermique comprenant une étape d'épitaxie du silicium suivie d'un recuit sous hydrogène, puis un recuit sous Argon à 1 200°C. Ces étapes permettent de proposer un SOI de 12nm ayant un état de surface ayant une faible rugosité. Le coût élevé de ce process, devant être réalisé en monoplaque, est dissuasif pour de la fabrication industrielle de transistors.

L'état de surface peut aussi être traité par un nettoyage chimique à base d'acide hydrofluorhydrique (HF) et d'ozone (O₃). Le mélange est utilisé dans le domaine photovoltaïque, mais la gestion des fluides HF/O₃ en simultané est complexe et dangereuse.

On connaît également pour effectuer des nettoyages d'oxyde de grille, d'utiliser l'ozone qui permet la formation d'un oxyde présentant peu de contaminants métalliques. Toutefois, l'oxyde formé est épais ce qui est contraignant car il contribue à une isolation globale plus grande, isolation tenant compte de deux composantes : l'oxyde formé par l'étape ozone en surface du substrat silicium et l'oxyde de grille de type SiO2 thermique ou High k processé dans une étape ultérieure à l'étape ozone. Il y a une diminution de la performance du transistor : le courant diminue du fait de la plus grande capacité de grille, plus grande épaisseur d'isolant.

Pour retirer ou affiner l'oxyde de grille, on utilise aussi un mélange chaud de peroxyde d'hydrogène (H₂O₂) et d'ammoniaque (NH₄OH) concentrés, faiblement dilués. Le mélange est utilisé à chaud, à une température supérieure à 60°C. Cette technologie est particulièrement néfaste pour l'état de surface et notamment la rugosité.

Le document WO 95/04372 décrit un procédé pour diminuer le nombre de particules de surface d'un semi-conducteur. L'objectif du document est de nettoyer la surface par des étapes de croissance d'oxyde et de retrait partiel d'oxyde de sorte à toujours maintenir de l'oxyde en surface. Seules des particules de l'ordre de 0,2 micromètres sont retirées. Le nettoyage est réalisé par une solution de peroxyde d'hydrogène et d'ammoniaque à chaud à une température de 80°C. Il n'est pas recherché d'améliorer la rugosité d'une surface de silicone.

La publication "Removal of Si (1 1 1) wafer surface etch pits generated in ammonia-peroxide clean-step" de Zhanwen Xiao et al. décrit un procédé pour éliminer un défaut cristallin volontairement formé à la surface. Le défaut cristallin est géométriquement contrôlé. Une solution de peroxyde d'hydrogène et d'ammoniaque à chaud à 70°C est utilisée. L'efficacité de nettoyage est reconnue mais cette solution présente un effet néfaste sur la rugosité. Il est préféré dans cette publication de replacer l'ammoniaque par de l'acide sulfurique H2SO4, de sorte à diminuer la concentration de OH- qui serait responsable de la dégradation de la rugosité.

Avec ces techniques, l'état de surface est modifié. Cela a deux conséquences :
- d'un point de vue électrique, la variabilité de la tension de grille est augmentée ;
- d'un point de vue technologique, la dispersion d'épaisseur à faible échelle peut être bloquante pour certaines étapes technologiques telles que l'épitaxie. En effet, la qualité de l'épitaxie dépend localement de l'épaisseur initiale de silicium.

Il existe donc le besoin de proposer un procédé de traitement de l'état de surface d'un substrat de silicium qui remédie à tout ou partie de ces inconvénients.

### EXPOSE DE L'INVENTION

A cet effet, la présente invention concerne un procédé de traitement de l'état de surface d'un substrat de silicium par voie chimique pour le contrôle de la rugosité caractérisé par le fait qu'il comprend au moins deux cycles de traitement successifs, chaque cycle de traitement comprend une première étape comportant la mise en contact du substrat de silicium avec une première solution comprenant de l'acide hydrofluorhydrique (HF) dilué dans de l'eau, puis une deuxième étape, réalisée à une température inférieure à 40°C, comportant la mise en contact du substrat de silicium avec une deuxième solution comprenant de l'ammoniaque (NH₄OH) et du peroxyde d'hydrogène (H₂O₂) dilués dans de l'eau (H₂O).

Ces étapes permettent à la fois un retrait de silicium, plus précisément de l'oxyde de silicium, et une oxydation. L'équilibre entre ces deux effets lors des étapes et cycles successifs améliore l'état de surface, plus particulièrement la rugosité tout en réalisant un retrait contrôlé.

De plus, l'utilisation de la deuxième solution à une température inférieure à 40°C contribue à limiter la gravure et obtenir une rugosité satisfaisante bien que cette solution soit connue dans l'état de la technique comme dégradant la rugosité de surface. L'utilisation à une température nettement plus basse que celle décrite dans l'art antérieur a permis de manière surprenante d'améliorer la rugosité dans la présente invention.

L'invention améliore plus particulièrement la microrugosité à l'échelle du micromètre.

Les éléments chimiques utilisés dans les cycles de traitement sont facilement accessibles et utilisables sans condition complexe.

Le procédé selon l'invention est aisément mis en oeuvre à bas coût.

Suivant des variantes cumulatives ou alternatives et non limitatives, le procédé est tel que :
- la rugosité RMS obtenue à l'issue des cycles de traitement est inférieure à 0,100 nm sur une zone de 1µmx1µm ; ainsi, les cycles de traitements successifs sont répétés jusqu'à l'obtention d'une rugosité RMS inférieure à 0,100 nanomètre sur une zone de 1µmx1µm.
- le procédé comprend de 2 à 15 cycles de traitement, préférentiellement de 4 à 10 cycles de traitement ;
- la température de la deuxième étape est comprise entre 1 et 40°C, préférentiellement entre 5 et 25°C, encore préférentiellement entre 18 et 25°C ;
- la température de la première étape est inférieure ou égale à 40°C ;
- la température de la première étape est comprise entre 1 et 40°C, préférentiellement entre 5 et 25°C, encore préférentiellement entre 18 et 25°C ;
- la dilution de la solution utilisée à la première étape est de 5 à 2000/1, préférentiellement de 50 à 500/1 pour de l'acide hydrofluorique (HF) à 49% massique ;
- la première étape est configurée pour retirer de 0,2 à 100nm, préférentiellement de 0,5 à 5nm d'oxyde de silicium ;
- la durée de la première étape est de 5 à 900 secondes, préférentiellement de 20 à 300 secondes ;
- le rapport en volume de l'ammoniaque (NH₄OH) à 28 à 30% massique et du peroxyde d'hydrogène (H₂O₂) à 28 à 30% massique dans la solution de la deuxième étape est compris entre 1 /10 et 10/1, préférentiellement entre 1/4 et 3/4 ;
- la solution de la deuxième étape est diluée de 5 à 1000 fois, préférentiellement de 20 à 200 ;
- la durée de la deuxième étape est de 10 secondes à 30 minutes, préférentiellement de 30 secondes à 5 minutes ;
- le procédé comprend après les au moins deux cycles de traitement une étape de nettoyage de la surface destinée à retirer la contamination métallique ;
- l'étape de nettoyage comprend la mise en contact d'une solution de nettoyage comprenant de l'acide chlorhydrique (HCl) dilué dans de l'eau ou une solution d'acide hydrochlorhydrique (HCl) à 37% massique et de peroxyde d'hydrogène (H₂O₂) à 29% dilués dans de l'eau (H₂O) dans un ratio en volume de 1/1/5 à 1/1/100 ;
- la première solution comprend un mélange d'acide hydrofluorhydrique (HF) et de fluorure d'ammonium (NH₄F) ou d'ammoniaque (NH₄OH) ;
- selon un mode de réalisation particulier, les cycles de traitements successifs sont répétés jusqu'à l'obtention d'une rugosité RMax inférieure à 0,100 nanomètre sur une zone de 1µmx1µm.

La présente invention concerne aussi un substrat de silicium dont la rugosité RMS est inférieure à 0,100 nm dans une zone de 1µmx1µm.

### EXPOSE DETAILLE DE L'INVENTION

La présente invention concerne un procédé de traitement de l'état de surface d'un substrat de silicium.

Le procédé selon l'invention est un traitement chimique.

Le procédé comprend au moins deux cycles de traitement, chaque cycle comprend au moins deux étapes.

La première étape comprend la mise en contact du substrat de silicium avec une première solution, comprenant avantageusement de l'acide hydrofluorhydrique (HF) dilué dans de l'eau.

La deuxième étape comprend la mise en contact du substrat de silicium avec une solution comprenant au moins avantageusement de l'ammoniaque (NH₄OH) et du peroxyde d'hydrogène (H₂O₂) dilués dans de l'eau.

Préférentiellement, la mise en contact se fait sur la surface du substrat. La surface à traiter peut être une surface de transistor planaire ou des flancs verticaux de transistor vertical (Fin Fet) ou encore des surfaces obliques telles que des pyramides du photovoltaïque.

La première étape a principalement une action de gravure de l'oxyde de silicium présent en surface du substrat en silicium. Préférentiellement, le retrait de l'oxyde de silicium varie de 0,5 à 5 nm.

Préférentiellement, la première solution comprenant de l'acide hydrofluorhydrique (HF) est fabriquée à partir d'acide hydrofluorhydrique (HF) à 49% massique dilué dans de l'eau déionisée. La dilution est comprise entre 5 et 2 000, préférentiellement de 50 à 500, encore plus précisément de l'ordre de 300.

Préférentiellement, la température des étapes, notamment de la première étape et de la deuxième étape, correspond à la température des solutions utilisées à ces étapes, respectivement la première solution et la deuxième solution.

Avantageusement, la température de la première solution varie de 1 à 40°C, préférentiellement entre 10 et 30°C, préférentiellement entre 5°et 25°C, encore préférentiellement à température ambiante soit entre 18 et 25°C.

La dilution et la température d'utilisation de la première solution diminuent la vitesse de gravure et permettent ainsi un retrait contrôlé.

A titre d'exemple, une solution d'acide hydrofluorhydrique (HF) à 49% diluée 300 fois à l'eau déionisée dont la température est de 25°C permet le retrait de 2nm d'oxyde de silicium pour une durée de mise en contact de 2 minutes.

La durée de la mise en contact de la première solution et du substrat est adaptée pour effectuer un retrait d'oxyde de silicium recherché. Avantageusement, la durée est de 5 à 900 secondes, préférentiellement de 20 à 300 secondes.

Selon une variante, la première solution comprend un mélange d'acide hydrofluorhydrique (HF)/fluorure d'ammonium (NH₄F) aussi dénommé BOE commercial *(Buffered Oxide Etching)* ou encore un mélange acide hydrofluorhydrique (HF) / ammoniaque (NH₄OH) dénommé BOE co-injecté. Le dernier mélange correspond au mélange HF/NH4F lorsque la réaction acide-base a eu lieu et que l'acide hydrofluorique est en excès.

Ces mélanges sont particulièrement utiles lorsque le substrat de silicium est au moins partiellement recouvert d'un masque de résine. Les mélanges sont adaptés en termes de pH pour ne pas endommager la résine tout en permettant une gravure, un retrait de l'oxyde de silicium satisfaisant.

La deuxième étape a principalement une action d'oxydation sur le substrat de silicium.

La deuxième solution comprend avantageusement de l'ammoniaque (NH₄OH) et du peroxyde d'hydrogène (H₂O₂) dilués dans de l'eau déionisée. Préférentiellement, la deuxième solution est fabriqué à partir de ammoniaque (NH₄OH) à 28 à 30% massique et de peroxyde d'hydrogène (H₂O₂) à 28 à 30% massique.

Avantageusement, le ratio NH₄OH/H₂O₂ est compris entre 1/10 et 10/1. Préférentiellement, le ratio NH₄OH/H₂O₂ est de 1/4 à 3/4. Le ratio s'entend en volume.

La dilution de la deuxième solution varie entre 5 et 1 000, préférentiellement, entre 20 et 200, plus préférentiellement de 100. Le facteur de dilution s'entend au regard du volume de l'ammoniaque NH₄OH introduit dans la deuxième solution.

Selon l'invention, la deuxième solution présente une température inférieure à 40°C, avantageusement comprise entre 1 et 40°C, préférentiellement, entre 5 et 25°C, plus préférentiellement à température ambiante entre 18 et 25°C.

L'utilisation de solution à des températures comprises entre 1 et 40°C et avantageusement assez basses c'est-à-dire inférieures ou égales à 25°C, préférentiellement entre 5 et 25°C, permet l'obtention d'un état de surface plus homogène et amélioré.

La durée de la mise en contact du substrat avec la deuxième solution est avantageusement de 20 secondes à 30 minutes, préférentiellement de 1 minute à 20 minutes, plus préférentiellement de 10 minutes.

Sans être tenu à une théorie, on peut penser que la deuxième solution comprend des espèces chimiques qui ont des effets différents à savoir un effet de gravure et un effet d'oxydation du silicium.

L'équilibre gravure/oxydation dépend notamment de la température de la solution. A des températures inférieures à 40°C, l'oxydation est majoritaire. L'état de surface et notamment la rugosité n'est pas affectée, voire elle est améliorée.

Les deux étapes du procédé selon l'invention sont préférentiellement effectuées l'une à la suite de l'autre sans rinçage ou étape intermédiaire. La succession de la première étape suivie de la deuxième étape constitue un cycle de traitement. Selon l'invention, le procédé comprend au moins deux cycles de traitement. Préférentiellement, le nombre de cycles est compris entre 4 et 15.

Selon un premier mode de réalisation, la mise en contact du substrat de silicium avec la première puis la deuxième solution s'effectue par immersion dans des bains successifs.

Selon un deuxième mode de réalisation, le substrat est soumis à des sprays successifs alternant les deux solutions.

De manière surprenante, l'état de surface du substrat de silicium est nettement amélioré après le procédé selon l'invention.

Selon une possibilité, après les au moins deux cycles de traitement, le procédé comprend une étape de nettoyage qui comprend la mise en contact du substrat avec une solution d'acide hydrochlorhydrique (HCl), préférentiellement à 37% massique, diluée dans l'eau. La dilution est de 5 à 1000, préférentiellement de 100 à 500, préférentiellement 300.

La durée de la mise en contact est avantageusement de 20 secondes à 30 minutes, préférentiellement de 1 à 10 minutes, plus préférentiellement de 5 minutes.

La solution est avantageusement à une température comprise entre 1° et 40°C, préférentiellement à température ambiante entre 18 et 25°C.

Selon une variante, la solution de l'étape de nettoyage comprend un mélange d'acide hydrochlorhydrique (HCl) et de peroxyde d'hydrogène (H₂O₂) dilués dans de l'eau déionisée. Préférentiellement, le ratio volumique entre l'acide hydrochlorhydrique (HCl) et le peroxyde d'hydrogène (H₂O₂) est de 1/1. La dilution est comprise entre 5 et 100.

L'acide hydrochlorhydrique (HCl) utilisé est préférentiellement à 37% massique et le peroxyde d'hydrogène (H₂O₂) est préférentiellement à 29% massique.

Cette étape de nettoyage est destinée à retirer la contamination métallique.

On entend plus particulièrement comme état de surface, la rugosité de la couche. Pour mesurer la rugosité d'un substrat, les fournisseurs utilisent généralement une sorte de convention standard et informent de la rugosité sur un scan de 30x30µm.

Dans le domaine de la microélectronique, il est toutefois préféré de mesurer la rugosité à l'échelle du micromètre (1µmx1µm) qui correspond à une zone locale suffisamment grande au regard des dimensions de l'ordre du nanomètre des dispositifs fabriqués. L'échelle micrométrique permet d'avoir une information efficace de la rugosité pour les propriétés du dispositif nanométrique. L'échelle de 30µmx30µm donne une information à plus grande échelle du comportement de la surface, par exemple oscillations, réseau récurrent.

Pour mesurer la rugosité, on peut utiliser la microscopie à force atomique (AFM) Deux types de mesure sont réalisés à savoir :
- RMS : Root Mean Square, aussi connue sous la référence Rq rugosité moyenne quadratique. Elle représente la moyenne quadratique des écarts de hauteur sur la longueur d'évaluation et mesurés par rapport à la ligne moyenne.
- RMax : Rugosité Maximale. Elle représente la plus grande distance entre le point le plus élevé et le point le plus bas pour la surface étudiée.

Le choix du nombre de cycles est effectué selon le résultat souhaité pour l'application du substrat.

Par exemple, pour des transistors sur film mince, c'est la mesure RMax qui est privilégiée pour avoir une rugosité homogène à l'échelle micrométrique. Pour un traitement de l'état de surface en vue d'un collage moléculaire direct, c'est plutôt le RMS qui doit être étudié à une échelle de 30x30µm.

L'utilisation de 4 cycles de traitement permet de réduire l'épaisseur d'un substrat de silicium de 12nm à 7nm. Le procédé permet un amincissement par voie chimique.

L'invention est particulièrement intéressante pour les pyramides du photovoltaïque. Le présent procédé peut être utilisé après la texturisation et avant les étapes de dépôts. Le procédé permet d'arrondir les sommets et les creux des pyramides tout en lissant les faces obliques. On note une nette amélioration des états d'interface entre le silicium et les couches disposées.

Le procédé selon l'invention peut également être utilisé pour le collage moléculaire direct. Il consiste en un empilement de deux structures l'une sur l'autre à petite échelle, par exemple locale, collage d'une puce sur une plaque ou d'une puce sur une puce ou à plus grande échelle par exemple collage plaque à plaque.

Ce type de collage implique au moins une surface de silicium dont l'état de surface doit être le plus lisse possible. L'utilisation du présent procédé permet d'augmenter la vitesse de collage, lors de l'adhésion, un renforcement de la surface d'interface de collage, diminuer la défectivité résultant du collage de deux plaques.

Le procédé selon l'invention permet également une meilleure croissance de couche notamment par épitaxie. On constate moins de défaut d'empilement. On s'intéresse ici au RMax. Pour déposer une couche, le seuil est optimisé car pour une épaisseur moyenne d'une couche de 3 nanomètres de moyenne, si la rugosité RMax est de 2-4 nanomètres soit 2 nanomètres, on ne peut procéder à une épitaxie alors que pour une même épaisseur moyenne et une rugosité RMax de 2,5-3,5 soit 1 nanomètre alors le dépôt est possible.

### EXEMPLE

Un procédé de traitement selon l'invention a été réalisé sur un substrat de silicium bulk avec 1 à 10 cycles de traitement.

A savoir, chaque cycle comprenant la pulvérisation des solutions sur la surface du substrat :
- 1^{ère} étape : 2 minutes d'une première solution d'acide hydrofluorhydrique (HF) à 49% diluée à l'eau déionisée 300 fois à 25°C puis
- 2^{ème} étape : 10 minutes d'une deuxième solution d'ammoniaque (NH₄OH) et peroxyde d'hydrogène (H₂O₂) dilués à l'eau déionisée. Le ratio étant de 1/2 entre l'ammoniaque à 29% et le peroxyde d'hydrogène à 29%. La dilution est de 100 fois. La solution est à 25°C.

A l'issue des deux cycles, une étape de nettoyage est réalisée pendant 5mn avec une solution d'acide hydrochlorhydrique (HCl) à 37% diluée 300 fois à 25°C.

Chaque cycle retire environ 1,2 nanomètre de silicium. La rugosité a été mesurée par AFM.

Les résultats sont donnés dans le tableau ci-après.

| **TRAITEMENTS** | **RMS (Ang)** | | **RMax (Ang)** | |
|---|---|---|---|---|
| | **30x30** | **1x1** | **30x30** | **1x1** |
| initial | 1,11 | 1,65 | 10,9 | 18,2 |
| **4 cycles** | 0,99 | **0,88** | 16,4 | **8,1** |
| **7 cyles** | 1,05 | **0,99** | 11,0 | **9,0** |
| **10 cycles** | 1,24 | **0,82** | 10,1 | **7,1** |

On s'aperçoit que dès quatre cycles, l'état de surface RMax est nettement amélioré à l'échelle micrométrique en passant d'une valeur de l'ordre de 18 Ang à une valeur inférieure à 10 Ang. On note également une diminution de la rugosité RMS à l'échelle micrométrique qui passe de l'ordre de 1,65 Ang à inférieure à 1 Ang.

On remarque même que jusqu'à 10 cycles, les valeurs du RMax et du RMS à l'échelle micrométrique sont encore plus faibles.

## Revendications

1. Procédé de traitement de l'état de surface d'un substrat de silicium par voie chimique pour le contrôle de la rugosité **caractérisé par le fait qu'**il comprend au moins deux cycles de traitement successifs, chaque cycle de traitement comprend :
- une première étape comportant la mise en contact du substrat de silicium avec une première solution comprenant de l'acide hydrofluorhydrique (HF) dilué dans de l'eau puis
- une deuxième étape, réalisée à une température inférieure à 40°C, comportant la mise en contact du substrat de silicium avec une deuxième solution comprenant de l'ammoniaque (NH₄OH) et du peroxyde d'hydrogène (H₂O₂) dilués dans de l'eau (H₂O).

2. Procédé selon la revendication précédente dans lequel les cycles de traitements successifs sont répétés jusqu'à l'obtention d'une rugosité RMS inférieure à 0,100 nanomètre sur une zone de 1µmx1µm.

3. Procédé selon l'une quelconque des revendications précédentes comprenant de 2 à 15 cycles de traitement, préférentiellement de 4 à 10 cycles de traitement.

4. Procédé selon l'une quelconque des revendications précédentes dans lequel la température de la deuxième étape est comprise entre 18 et 25°C.

5. Procédé selon l'une quelconque des revendications précédentes dans lequel la température de la première étape est inférieure ou égale à 40°C.

6. Procédé selon l'une quelconque des revendications précédentes dans lequel la température la première étape est comprise entre 18 et 25°C.

7. Procédé selon l'une quelconque des revendications précédentes dans lequel la dilution de la solution utilisée à la première étape est de 50 à 500/1, pour de l'acide hydrofluorhydrique (HF) à 49% massique.

8. Procédé selon l'une quelconque des revendications précédentes dans lequel le substrat de silicium mis en contact dans la première étape comprend de l'oxyde de silicium et on retire de 0,5 à 5 nanomètres dudit oxyde de silicium au cours de ladite première étape.

9. Procédé selon l'une quelconque des revendications précédentes dans lequel la durée de la mise en contact de la première étape est de 20 à 300 secondes.

10. Procédé selon l'une quelconque des revendications précédentes dans lequel le rapport en volume de l'ammoniaque (NH₄OH) à 29% massique et du peroxyde d'hydrogène (H₂O₂) à 29% massique dans la solution de la deuxième étape est compris entre 1/10 et 10/1, préférentiellement entre 1/4 et 3/4.

11. Procédé selon l'une quelconque des revendications précédentes dans lequel la solution de la deuxième étape est diluée de 5 à 1000 fois, préférentiellement entre 20 et 200 fois.

12. Procédé selon l'une quelconque des revendications précédentes dans lequel la durée de la mise en contact de la deuxième étape est de 30 secondes à 5 minutes.

13. Procédé selon l'une quelconque des revendications précédentes comprenant après les au moins deux cycles de traitement une étape de nettoyage de la surface destinée à retirer la contamination métallique.

14. Procédé selon la revendication précédente dans lequel l'étape de nettoyage comprend la mise en contact d'une solution de nettoyage comprenant de l'acide chlorhydrique dilué dans de l'eau ou une solution d'acide hydrochlorhydrique (HCl) à 37% massique et de peroxyde d'hydrogène (H₂O₂) à 29% massique dilués dans de l'eau (H₂O) dans un ratio en volume de 1/1/5 à 1/1/100.

15. Procédé selon l'une quelconque des revendications précédentes dans lequel la première solution comprend un mélange d'acide hydrofluorhydrique (HF) et de fluorure d'ammonium (NH₄F) ou d'ammoniaque (NH₄OH).

16. Substrat de silicium obtenu par le procédé selon l'une quelconque des revendications précédentes et ayant une rugosité RMS inférieure à 0,100 nm dans une zone de 1µmx1µm.
